Europäisches Patentamt

European Patent Office

Office européen des brevets

(19)

(11) EP 0 795 222 B1

(12) **EUROPÄISCHE PATENTSCHRIFT**

(45) Veröffentlichungstag und Bekanntmachung des Hinweises auf die Patenterteilung:
**26.08.1998 Patentblatt 1998/35**

(21) Anmeldenummer: **95935841.7**

(22) Anmeldetag: **25.10.1995**

(51) Int Cl.$^6$: **H02H 3/38**, H02H 3/16, G01R 31/02

(86) Internationale Anmeldenummer:
**PCT/DE95/01524**

(87) Internationale Veröffentlichungsnummer:
**WO 96/13888 (09.05.1996 Gazette 1996/21)**

(54) **VERFAHREN ZUM ERFASSEN EINES ERDKURZSCHLUSSES AUF EINER ELEKTRISCHEN ENERGIEÜBERTRAGUNGSLEITUNG**

PROCESS FOR DETECTING A GROUND FAULT IN AN ELECTRIC ENERGY TRANSMISSION LINE

PROCEDE DE DETECTION D'UN DEFAUT A LA TERRE DANS UNE LIGNE DE TRANSMISSION D'ENERGIE ELECTRIQUE

(84) Benannte Vertragsstaaten:
**DE FR GB IT**

(30) Priorität: **27.10.1994 DE 4439499**

(43) Veröffentlichungstag der Anmeldung:
**17.09.1997 Patentblatt 1997/38**

(73) Patentinhaber: **SIEMENS AKTIENGESELLSCHAFT
80333 München (DE)**

(72) Erfinder: **KAISER, Steffen
D-10407 Berlin (DE)**

(56) Entgegenhaltungen:
**EP-A- 0 079 504          EP-A- 0 330 851
WO-A-93/19507          GB-A- 2 012 505**

**Beschreibung**

Die Erfindung bezieht sich auf ein Verfahren zum Erfassen eines Erdkurzschlusses auf einer elektrischen Energieübertragungsleitung mit drei Phasenleitern, bei dem nach erfolgter Anregung aus den Strömen in den Phasenleitern abgeleitete Ströme und/oder aus den Spannungen an den Phasenleitern abgeleitete Spannungen auf das Erreichen von Grenzwerten überwacht werden und bei einem Überschreiten eines Grenzwertes hinsichtlich mindestens eines abgeleiteten Stromes oder bei einem Unterschreiten eines weiteren Grenzwertes hinsichtlich mindestens einer abgeleiteten Spannung ein einen einpoligen oder mehrpoligen Fehler angebendes Fehlerkennzeichnungssignal erzeugt wird.

Ein Verfahren dieser Art ist allgemein bekannt; nur beispielsweise wird auf das Buch von H. Titze "Fehler und Fehlerschutz in elektrischen Drehstromanlagen" , 1953, zweiter Band, Seite 48 und auf das Buch von H. Clemens und K. Rothe "Schutztechnik in Elektroenergiesystemen", 1991, Seite 211, verwiesen. Bei der Durchführung dieses bekannten Verfahrens hat es sich gezeigt, daß in vielen Fallen nicht zuverlässig festgestellt werden kann, ob es sich bei einem aufgetretenen Erdkurzschluß um einen einpoligen oder einen mehrpoligen Erdkurzschluß handelt und welcher Phasenleiter jeweils vom Erdkurzschluß betroffen ist.

Der Erfindung liegt die Aufgabe zugrunde, ein Verfahren zum Erfassen eines Erdkurzschlusses auf einer elektrischen Energieübertragungsleitung mit drei Phasenleitern anzugeben, mit dem nicht nur zuverlässig zwischen einem einpoligen und einem mehrpoligen Erdkurzschluß unterschieden werden kann, sondern mit dem auch sicher jeweils der oder die Phasenleiter ermittelt werden kann bzw. können, der bzw. die vom Erdkurzschluß befallen ist/ sind.

Zur Lösung dieser Aufgabe werden bei einem Verfahren der eingangs angegebenen Art erfindungsgemäß beim Ausbleiben eines Fehlerkennzeichnungssignals aus den abgeleiteten Strömen eine dem Strom des Nullsystems entsprechende Meßgröße und eine dem Strom des Gegensystems entsprechende weitere Meßgröße gebildet, und es wird bei einem Erdkurzschluß eines Phasenleiters bei einem einen vorgegebenen Phasengrenzwinkel unterschreitenden Phasenwinkel zwischen den beiden Meßgrößen ein Hilfssignal erzeugt; die aus den Strömen in den beiden jeweils anderen Phasenleitern abgeleiteten Ströme werden dahingehend überwacht, ob jeder dieser abgeleiteten Ströme in seiner Größe unterhalb eines Bruchteils des erfaßten Erdstromes liegt, und es wird ein weiteres Hilfssignal bei jeweils den Bruchteil des Erdstromes unterschreitenden Werten der abgeleiteten Strömen erzeugt; die Hilfssignale werden in einer Logikschaltung überprüft, die beim Vorliegen beider Hilfssignale ein den Erdkurzschluß des einen Phasenleiters kennzeichnendes Fehleridentifizierungssignal abgibt.

Es ist zwar bekannt, (Aufsatz "Erfassung hochohmiger Erdfehler" in der Zeitschrift "ABB Technik" 1/90), Gegen- und Nullkomponenten für einen empfindlichen Erdkurzschlußrichtungsschutz zu verwenden, jedoch werden dabei die Komponenten zur genauen Richtungsbestimmung benutzt, also zur genauen Feststellung, ob ein Fehler vor oder hinter einem Erdkurzschlußrichtungsrelais liegt.

Der wesentliche Vorteil des erfindungsgemäßen Verfahrens besteht darin, daß nach erfolgter Anregung aufgrund eines Erdkurzschlusses sehr zuverlässig die Phasenleiter bestimmt werden können, die einen Erdkurzschluß aufweisen. Dies ist darauf zurückzuführen, daß nach Ausbleiben eines Fehlerkennzeichnungssignals überprüft wird, ob der Phasenwinkel zwischen der einen Meßgröße und der weiteren Meßgröße einen vorgegebenen Phasengrenzwinkel unterschreitet. Neben diesem Kriterium wird ferner überwacht, ob die Ströme in den jeweils anderen Phasenleitern unterhalb eines Bruchteils des erfaßten Erdstromes liegen; sind beide Kriterien erfüllt, werden die Hilfssignale erzeugt. Liegen beide Hilfssignale vor, dann wird das den Erdkurzschluß des einen Phasenleiters kennzeichnende Fehleridentifierungssignal abgegeben.

Der Erfindung liegt unter anderem die Erkenntnis zugrunde, daß sich bei einer elektrischen Energieübertragungsleitung mit drei Phasenleitern aus dem Phasenwinkel zwischen einer dem Strom des Gegensystems entsprechenden Meßgröße und einer dem Strom des Nullsystems entsprechenden weiteren Meßgröße ein Kriterium zur Phasenselektion im Erdkurzschlußfalle herleiten läßt. Dabei wird für das "Gegensystem" und das "Nullsystem" sowie auch für das "Mitsystem" auf die Definitionen zurückgegriffen, wie sie beispielsweise dem Buch von R. Roeper "Kurzschlußströme in Drehstromnetzen" 1984, 6. Auflage, Seiten 48 bis 53 entnehmbar sind.

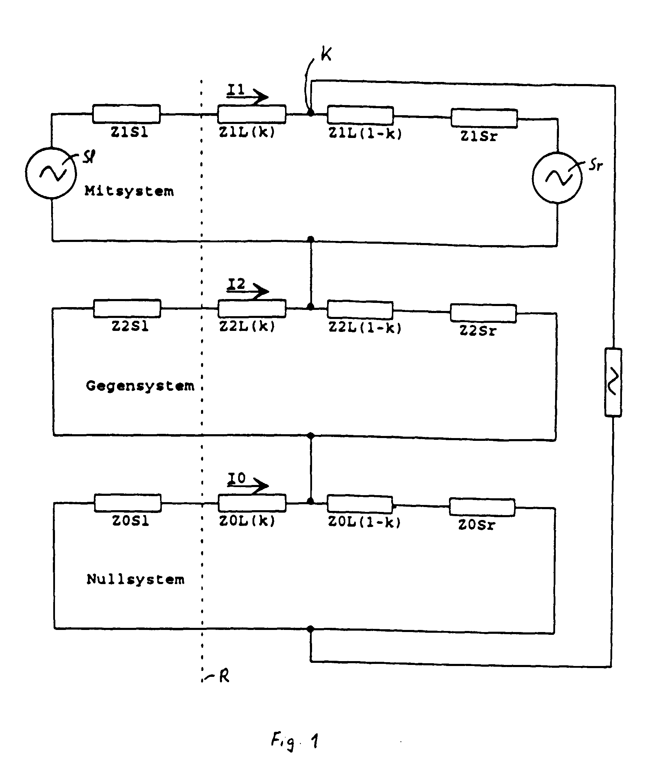

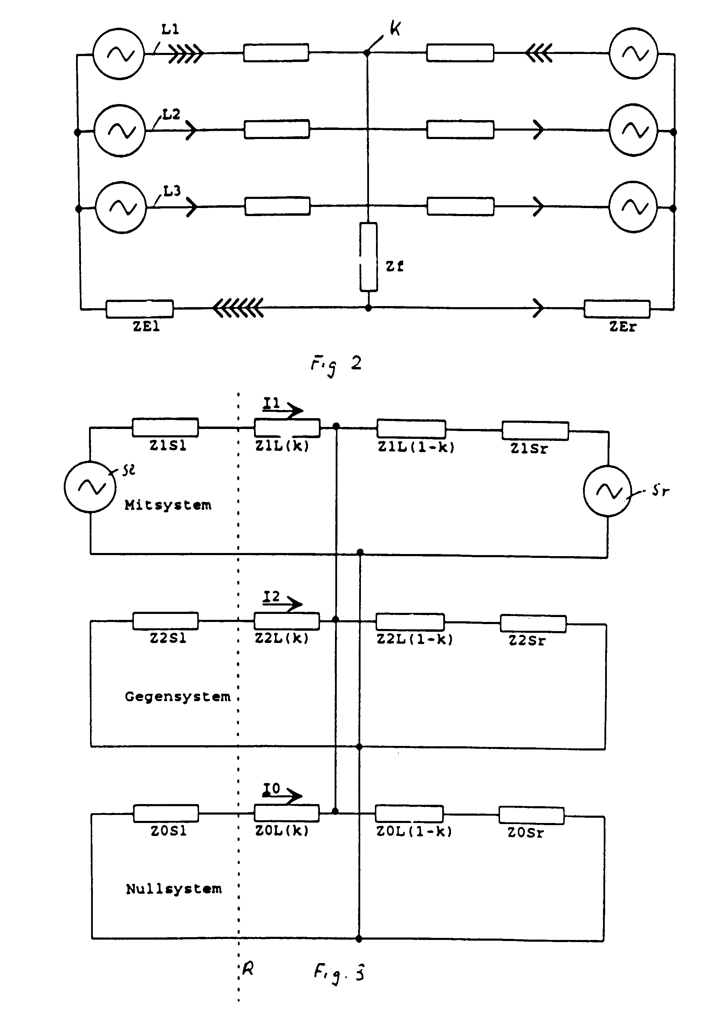

Unter Berücksichtigung dieses theoretischen Fundamentes kann nämlich das Ersatzschaltbild einer dreiphasigen elektrischen Energieübertragungsleitung in symmetrischen Komponenten mit zweiseitiger Speisung und einem einpoligen Erdkurzschluß hinsichtlich eines Phasenleiters L1 so dargestellt werden, wie es Figur 1 zeigt. Dabei ist von einer Netzkonfiguration gemäß Fig. 2 ausgegangen, bei der eine elektrische Energieübertragungsleitung mit drei Phasenleitern L1, L2 und L3 zweiseitig gespeist ist und bezüglich des Phasenleiters L1 einen Erdkurzschluß an der Stelle K aufweist. Zf bezeichnet die Fehlerimpedanz, während die (teilweisen) Erdimpedanzen mit ZEl und ZEr bezeichnet sind. Mit der Anzahl der Pfeile ist in den einzelnen Stromzweigen der Fig. 2 die unterschiedliche Größe des jeweiligen Stromes gekennzeichnet. In Figur 3 ist ein entsprechendes Ersatzschaltbild bei zweiseitiger Einspeisung und bei zweipoligem Erdkurzschluß dargestellt. In beiden Darstellungen ist jeweils mit Sl eine Speisequelle der elektrischen Energieübertragungsleitung und mit Sr die zweite Speisequelle bezeichnet. Jede der Speisequellen Sl und Sr hat eine innere Impedanz, die bei den Darstellungen in symmetrischen Komponenten gemäß den Figuren 1 und 2 in eine Impedanz Z1sl im Mitsystem, eine weitere Impedanz Z2sL im Gegensystem und eine Impedanz Z0sl im Nullsystem zerfällt. Entsprechend sind die Impedanzen der Speisequelle Sr in den Figuren 1 und 2 mit Z1sr im Mitsystem, Z2sl im Gegensystem und Z0sr im Nullsystem bezeichnet. Die Impedanz der elektrischen Energieübertragungsleitung ist bei einem angenommenen Fehler bzw. Erdkurzschluß an der Stelle K im Mitsystem mit Z1L(k) vom Relaiseinbauort R bis zur Fehlerstelle K gerechnet angegeben, so daß sich für die Impedanz der Energieübertragungsleitung von der Fehlerstelle K bis zur weiteren Speisequelle Sr im Mitsystem für die Leitungsimpedanz der Wert Z1L(1-k) ergibt. Der Strom im Mitsystem ist mit I1 bezeichnet.

Die Figuren 1 und 3 lassen ferner erkennen, daß die entsprechenden Leitungsimpedanzen im Gegensystem mit Z2L(k) und mit Z2L(1-k) und der Strom des Gegensystems mit I2 bezeichnet sind. Der Strom im Nullsystem ist in beiden Figuren 1 und 2 mit I0 bezeichnet; er durchfließt die Impedanz Z0L(k), die durch die weitere Impedanz Z0L (1-k) zur Leitungsimpedanz im Nullsystem ergänzt wird.

Aus der Figur 1 läßt sich im einzelnen weiter entnehmen, daß bei einem einpoligen Fehler in dem Phasenleiter L1 einer elektrischen Energieübertragungsleitung für den Nullstrom I0 die folgende Beziehung (1) gilt:

$$I0 = 3 \cdot I_f \cdot \frac{\underline{Z}_{0L}(1-k) + \underline{Z}_{0Sr}}{\underline{Z}_{0Sl} + \underline{Z}_{0SL}(k) + \underline{Z}_{0Sr}} \tag{1}$$

Dabei gibt $I_f$ den Fehlerstrom an.

Der Gegenstrom I2 läßt sich gemäß folgender Beziehung (2) errechnen:

$$I2 = 3 \cdot I_f \cdot \frac{\underline{Z}_{2L}(1-k) + \underline{Z}_{2Sr}}{\underline{Z}_{2Sl} + \underline{Z}_{2SL}(k) + \underline{Z}_{2Sr}} \tag{2}$$

Da die Impedanzen des Nullsystems und die Impedanzen des Gegensystems etwa den gleichen Winkel aufweisen, läßt sich für den Phasenwinkel $\varphi(I0, I2)$ zwischen dem Strom I0 des Nullsystems und dem Strom I2 des Gegensystems folgende Beziehung (3) aufstellen:

$$\varphi(\underline{I0}/\underline{I2}) \approx 0° \tag{3}$$

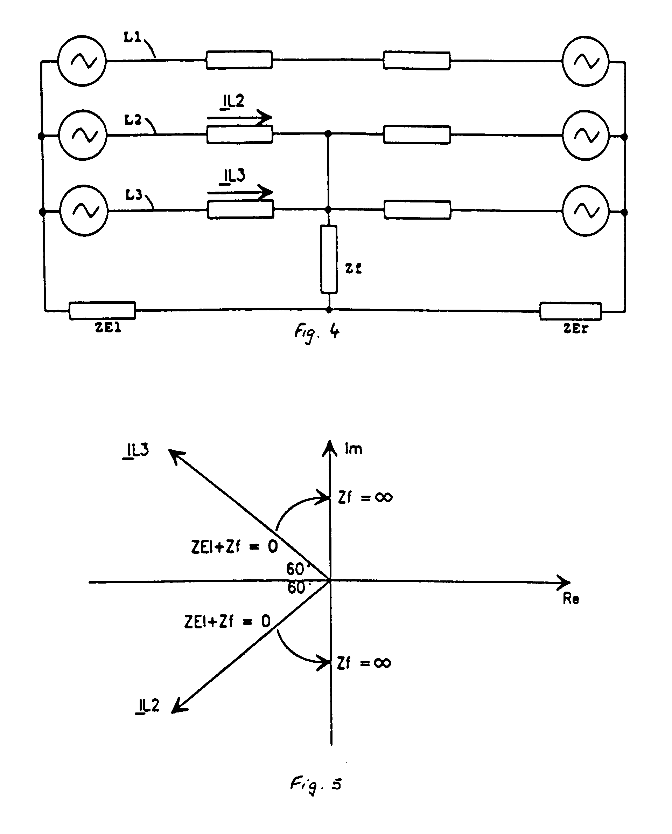

Für einen zweipoligen Erdkurzschluß der Phasenleiter L2 und L3 mit Erde E, wie er in Fig. 4 in einer der Fig. 2 ähnlichen Darstellungsweise gezeigt ist, gelten die nachstehenden Beziehungen (4) und (5):

$$\underline{I0} = \frac{\underline{U}_{0f}}{\underline{Z}_{0Sl} + \underline{Z}_{0L}(k)} \tag{4}$$

$$\underline{I2} = \frac{\underline{U}_{2f}}{\underline{Z}_{2Sl} + \underline{Z}_{2L}(k)} \tag{5}$$

In diesen Gleichungen (4) und (5) bedeuten $U_{0f}$ die Spannung des Nullsystems im Fehlerfall und die Größe $U_{2f}$ die Spannung des Gegensystems im Fehlerfall. Da das Gegensystem mit dem Nullsystem parallelgeschaltet ist, gilt

$$U_{0f} = U_{2f} \tag{6}$$

Daraus wiederum folgt, daß auch bei einem zweipoligen Erdkurzschluß zwischen den Phasenleitern L2 und L3 sowie Erde die Beziehung (7) gilt:

$$\varphi(\underline{I0}/\underline{I2}) \approx 0° \tag{7}$$

Dies zeigt zunächst einmal, daß bei einem einpoligen Erdkurzschluß des Phasenleiters L1 und bei einem zweipoligen Erdkurzschluß zwischen den Phasenleitern L2 und L3 sowie Erde hinsichtlich des Phasenwinkels zwischen den Strömen I0 und I2 des Null- und des Gegensystems kein Unterschied auftritt, so daß anhand allein dieses Kriteriums keine ausreichende Unterscheidung zwischen den beiden Fehlern möglich ist.

Berücksichtigt man, daß sich die Ströme I0 und I2 gemäß den nachfolgenden Gleichungen (9) und (10) bilden lassen mit a = i - 0,5 + j . 0,87 und a$^2$ = - 0,5 - j . 0,87

$$\underline{I}0 = \frac{1}{3} \cdot (\underline{I}L1 + \underline{I}L2 + \underline{I}L3) \tag{9}$$

$$\underline{I}2 = \frac{1}{3} \cdot \left(\underline{I}L1 + a^2 \underline{I}L2 + a\underline{I}L3\right) \tag{10}$$

dann können die Verhältnisse bezüglich des Phasenwinkels zwischen dem Strom I0 des Nullsystems und dem Strom I$_2$ des Gegensystems für die übrigen denkbaren Fehlerfälle ohne weiteres hergeleitet werden.

So ergibt sich bei einem einpoligen Erdkurzschluß des Phasenleiters L2 für den Phasenwinkel φ(I0/I2) folgende Beziehung (11), die auch für einen zweipoligen Fehler zwischen den Phasenleitern L1 und L3 sowie Erde E gilt:

$$\varphi(\underline{I}0/\underline{I}2) \approx 240° \tag{11}$$

Für einen einpoligen Fehler des Phasenleiters L3 gegen Erde und einen zweipoligen Fehler zwischen den Phasenleitern L1 und L2 sowie Erde E ergibt sich die folgende Beziehung (12):

$$\varphi(\underline{I}0/\underline{I}2) \approx 120° \tag{12}$$

Wird bei dem erfindungsgemäßen Verfahren eine dem Strom I0 des Nullsystems proportionale Meßgröße und eine dem Strom I2 des Gegensystems proportionale weitere Meßgröße zur Auswertung herangezogen, dann lassen sich aus den obigen Darlegungen folgende Schlußfolgerungen ziehen:

Ist bei einem einpoligen oder zweipoligen Erdkurzschluß der Phasenwinkel zwischen der einen und der weiteren Meßgröße etwa 0°, so sind die Phasenleiter L2 und L3 entweder die zwei nicht am Erdkurzschluß beteiligten Leiter eines einpoligen Erdkurzschlusses des Phasenleiters L1 oder es sind die zwei am Fehler beteiligten Leiter eines zweipoligen Erdkurzschlusses.

Ist bei einem einpoligen oder zweipoligen Erdkurzschluß der Phasenwinkel etwa 120°, so sind die Phasenleiter L1 und L2 entweder die zwei nicht am Fehler beteiligten Leiter eines einpoligen Erdkurzschlusses des Phasenleiters L3 oder es sind die zwei am Fehler beteiligten Leiter eines zweipoligen Erdkurzschlusses.

Beträgt bei einem einpoligen oder zweipoligen Erdfehler der Phasenwinkel zwischen den beiden Meßgrößen etwa 240°, so sind die Leiter L1 und L3 entweder die zwei nicht am Fehler beteiligten Leiter eines einpoligen Erdkurzschlusses des Phasenleiters L2 oder es sind die zwei am Fehler beteiligten Leiter eines zweipoligen Erdkurzschlusses.

Ist eine dieser Phasenbeziehungen gegeben, dann wird ein Hilfssignal erzeugt.

Bei der geschilderten Sachlage bedarf es eines weiteren Kriteriums, um zuverlässig einen einpoligen von einem zweipoligen Erdkurzschluß unterscheiden zu können und um darüber hinaus einen einpoligen Erdkurzschluß einem bestimmten Phasenleiter sicher zuordnen zu können. Dieses zweite Kriterium wird dadurch gewonnen, daß - bezogen auf den zur Bildung der einen und der weiteren Meßgröße herangezogenen Phasenleiter, z.B. L1 - die beiden jeweils anderen Phasenleiter, z. B. L2 und L3 hinsichtlich ihrer Ströme untersucht werden. Aus den in diesen beiden Phasenleitern fließenden Strömen abgeleitete Ströme werden dahingehend überwacht, ob jeder dieser abgeleiteten Ströme in seiner Größe unterhalb eines Bruchteils des erfaßten Erdstromes liegt. Dem liegt die Erkenntnis zugrunde, daß bei zweipoligen Erdkurzschlüssen über die zwei am Fehlerfall beteiligten Phasenleiter zwei Fehlerströme fließen, die in ihrer Phasenlage zwischen 120° und 180° zueinander liegen. Diese Fehlerströme sind mindestens so groß wie I$_E$/ $\sqrt{3}$ .

Zur Erläuterung dieses Kriteriums wird nochmals auf die Figur 4 zurückgegriffen. Bei dem angenommenen zweipoligen Erdkurzschluß fließen über die Phasenleiter L2 und L3 Ströme IL2 und IL3. Ist die durch die Impedanz Zf und durch die Teilimpedanz ZEI der Erdleitung gebildete Impedanz zum Sternpunkt gleich Null, dann sind die beiden Ströme IL2 und IL3 um 120° in der Phase gedreht. Nimmt die Impedanz zum Sternpunkt zu, dann werden diese beiden Ströme gezwungen, über die eigenen Leiter zur Spannungsquelle zurückzufließen, das heißt, der Phasenwinkel zwischen den Strömen IL2 und IL3 steigt bis zum Grenzfall von 180° an. Das Zeigerbild in der Figur 5 verdeutlicht diesen Sachverhalt. Da sich der Erdstrom I$_E$ aus den beiden Fehlerströmen IL2 und IL3 zusammensetzt, ergibt sich, daß der Fehlerstrom immer größer oder gleich groß $I_E/\sqrt{3}$ . sein muß. Sind also beide Fehlerströme IL2 und IL3 kleiner als ein sich aus der obigen Darstellung anbietender vorgegebener Bruchteil des Erdstromes $I_E$, dann läßt dies einen Rückschluß darauf zu, daß ein zweipoliger Fehler nicht vorliegt. Ein dann erzeugtes weiteres Hilfssignal signalisiert dann also, daß ein einpoliger Erdkurzschluß aufgetreten ist. Eine Verknüpfung des weiteren Hilfssignals mit dem einen Hilfssignal in der Logikschaltung läßt dann eine zuverlässige Aussage darüber zu, daß ein einpoliger Fehler im Phasenleiter L1 (beim dargestellten Fall) vorliegt.

Das weitere Hilfssignal ist aber nicht in allen denkbaren Fällen ausreichend, um mit Sicherheit einen einpoligen Fehler auf einem bestimmten Phasenleiter feststellen zu können. Deshalb wird es gemäß einer Weiterbildung des erfindungsgemäßen Verfahrens als vorteilhaft angesehen, wenn die aus den Strömen in den beiden jeweils anderen Phasenleitern abgeleiteten Ströme dahingehend überwacht werden, ob der von ihnen gebildete Phasenwinkel unterhalb einer vorgegebenen Phasendifferenz liegt; es wird ein zusätzliches Hilfssignal bei die Phasendifferenz unterschreitendem Phasenwinkel erzeugt, und das zusätzliche Hilfssignal wird in der Logikschaltung überprüft, die beim Vorliegen des einen und des weiteren oder des zusätzlichen Hilfssignals das den Erdkurzschluß des einen Phasenleiters kennzeichnende Fehleridentifizierungssignal abgibt.

Dieses zusätzliche Kriterium zur Gewinnung eines den Erdkurzschluß des einen Phasenleiter L1 kennzeichnenden Fehleridentifizierungssignals läßt sich anhand der Figur 2 erläutern. Liegt bei diesem Fehlerfalle der Ort des Erdkurzschlusses außerhalb der elektrischen Mitte der in der Figur 2 dargestellten Anordnung, dann fließen Ausgleichsströme, deren Phasenlage gleich sein muß, da die Impedanzen der Phasenleiter L2 und L3 gleich sind und die Stromteilerregel zur Anwendung kommt. Ist also der Phasenwinkel zwischen den beiden durch die jeweils anderen Phasenleiter L2 und L3 fließenden Ströme etwa Null, dann stellt dieses ein zusätzliches Kriterium für einen einpoligen Erdkurzschluß mit Ausgleichs strömen dar.

Bei besonders schwierig zu erfassenden Erdkurzschlüssen, nämlich bei Erdkurzschlüssen unter starken Lasteinflüssen, kann es erfahrungsgemäß vorkommen, daß auch ein Fehleridentifizierungssignal nicht erzeugt wird, obwohl die oben geschilderten Kriterien abgefragt worden sind. In diesem Falle ist es vorteilhaft, aus den Strömen in den Phasenleitern den Lastanteil herauszurechnen. Da der Strom des Nullsystems und der Strom des Gegensystems an sich nicht vom Laststrom abhängig sind, wird eine Laststromkorrektur nur zur Erzielung eines genauen Phasenvergleichs vorgenommen. Dabei wird davon ausgegangen, daß sich die Last nach Eintreten eines Erdkurzschlusses nicht ändert. Da sich der Last- und der Fehlerstrom überlagern, ergibt die Differenz des Stromes durch den jeweiligen Leiter nach dem Auftreten eines Erdkurzschlusses und dem Strom durch denselben Phasenleiter vor dem Eintreten eines Erdkurzschlusses den durch den Erdkurzschluß verursachten Strom.

Dementsprechend werden gemäß einer weiteren vorteilhaften Ausgestaltung des erfindungsgemäßen Verfahrens beim Ausbleiben eines Fehleridentifizierungssignals Stromdifferenzmeßgrößen gebildet, indem bezüglich jedes Phasenleiters von jedem abgeleiteten Strom jeweils ein abgeleiteter Stromwert subtrahiert wird, der aus dem vor der Anregung fließenden Strom im jeweiligen Phasenleiter gebildet wird, und es wird bei einem Erdkurzschluß eines Phasenleiters bei einem einen vorgegebenen Phasengrenzwinkel unterschreitenden Phasenwinkel zwischen den beiden Meßgrößen ein viertes Hilfssignal erzeugt; die Stromdifferenzmeßgrößen werden dahingehend überwacht, ob jede dieser Stromdifferenzmeßgrößen in ihrer Größe unterhalb eines Bruchteils des erfaßten Erdstromes liegt, und es wird ein fünftes Hilfssignal bei jeweils den Bruchteil des Erdstromes unterschreitenden Werten der abgeleiteten Ströme erzeugt, und es werden die vierten und fünften Hilfssignale in einer zweiten Logikschaltung überprüft, die beim Vorliegen dieser beiden Hilfssignale ein den Erdkurzschluß des einen Phasenleiters kennzeichnendes Fehleranzeigesignal abgibt.

Auch bei dieser Ausgestaltung des erfindungsgemäßen Verfahrens mit Laststromkorrektur kann eine weitere Verfeinerung dadurch erreicht werden, daß die den beiden jeweils anderen Phasenleitern zugeordneten Stromdifferenzmeßgrößen dahingehend überwacht werden, ob der von ihnen gebildete Phasenwinkel unterhalb einer vorgegebenen Phasendifferenz liegt, und es wird ein sechstes Hilfssignal bei die Phasendifferenz unterschreitendem Phasenwinkel erzeugt, und das sechste Hilfssignal in der zweiten Logikschaltung überprüft, die beim Vorliegen des vierten und des fünften oder des sechsten Hilfssignals das den Erdkurzschluß des einen Phasenleiters kennzeichnende Fehleranzeigesignal abgibt.

Mit dieser Ausgestaltung des erfindungsgemäßen Verfahrens lassen sich mit großer Sicherheit und Zuverlässigkeit alle einpoligen Erdkurzschlüsse auf einer dreiphasigen elektrischen Energieübertragungsleitung ermitteln. Dies bedeutet andererseits auch, daß ein Ausbleiben eines Fehleranzeigesignals ein sicheres Zeichen dafür ist, daß ein mehrpoliger Erdkurzschluß aufgetreten ist.

Zur weiteren Erläuterung der Erfindung ist in

Figur 6    ein Übersichts-Flußdiagramm zur Erläuterung des Ablaufs des erfindungsgemäßen Verfahrens in seinen wesentlichen Zügen, in

Figur 7    eine im Rahmen des erfindungsgemäßen Verfahrens vorteilhaft anwendbare Logikanordnung zur Überprüfung der Phasenströme und Phasenspannungen auf Über- bzw. Unterschreiten von Grenzwerten, in

Figur 8    ein Blockschaltbild einer Anordnung zum Ermitteln eines einpoligen Fehlers an einem Phasenleiter L1, in

Figur 9    ein Blockschaltbild einer Anordnung zum Ermitteln eines einpoligen Erdkurzschlusses auf einem Phasenleiter L3, in

Figur 10   ein zusätzliches Blockschaltbild einer Anordnung zum Ermitteln eines einpoligen Erdkurzschlusses des Phasenleiters L2 und in

Figur 11   ein weiteres Blockschaltbild zum Ermitteln eines einpoligen Erdkurzschlusses am Phasenleiter L1 mit Laststromkorrektur dargestellt.


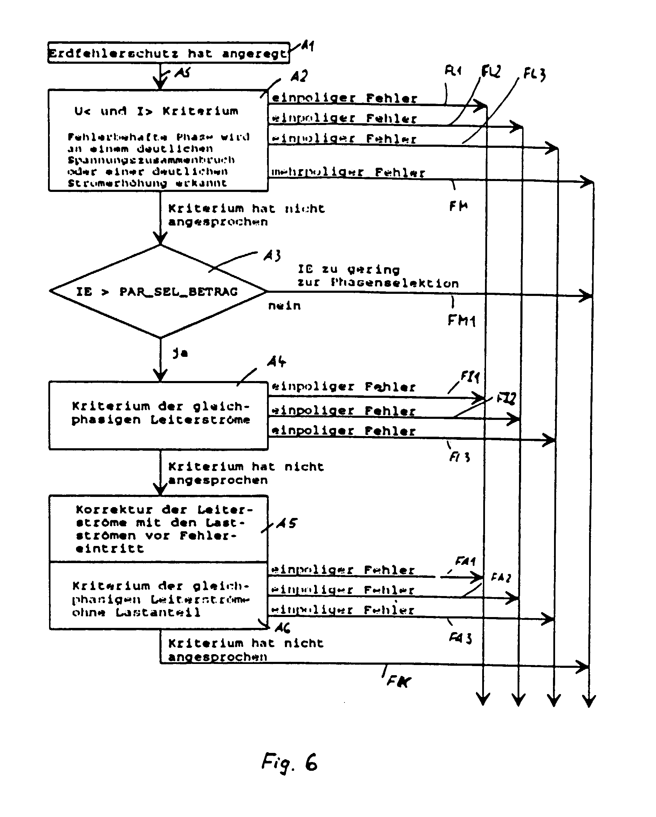

Das Flußdiagramm gemäß Figur 6 zeigt einen ersten Block A1, in dem ein Anregesignal AS erzeugt wird, wenn auf einer nicht dargestellten, zu überwachenden Energieübertragungsleitung mit den Phasenleitern L1 bis L3 ein Erdkurzschluß aufgetreten ist. Auf das Anregesignal AS hin wird in einem nachgeordneten Block A2 untersucht, ob der Strom in einem der Phasenleiter L1, L2 oder L3 oberhalb eines vorgegebenen Grenzwertes liegt oder ob die Spannung an einem der Phasenleiter L1 bis L3 zusammengebrochen ist. Ist entweder das eine oder das andere - oder beides - der Fall, dann wird ein Fehlerkennzeichnungssignal FL1, FL2, FL3 oder FM abgegeben, wodurch ein einpoliger Erdkurzschluß des Phasenleiters L1 bis L3 oder ein mehrpoliger Fehler FM angezeigt wird.

Ist von dem Block A2 trotz Beaufschlagung mit dem Anregesignal AS keines der Fehlerkennzeichnungssignale FL1 bis FM erzeugt worden, dann wird in einer nachgeordneten Verzweigung A3 überprüft, ob der erfaßte Erdstrom $I_E$ oberhalb eines vorgewählten Wertes liegt. Ist der Erdstrom $I_E$ relativ gering, dann wird dies als Anzeichen für einen mehrpoligen Fehler angesehen; es wird ein Signal FM1 erzeugt. Ist der Erdstrom $I_E$ dagegen größer als der vorgegebene Wert, dann wird ein nachfolgender Block A4 aktiviert, indem - wie unten noch näher erläutert wird- mittels mehrerer Hilfsgrößen Fehleridentifizierungssignale FI1 bis FI3 erzeugt werden, die einpolige Fehler auf den Phasenleitern L1, L2 oder L3 kennzeichnen.

Werden keine Fehleridentifizierungssignale FI1 bis FI3 erzeugt, dann wird ein weiterer Block A5 aktiv, in dem zunächst die oben bereits erwähnte Laststromkorrektur vorgenommen wird. Anschließend wird in einem Block A6 in ähnlicher Weise wie in dem Block A4 mittels ergänzender Hilfsgrößen überprüft, ob Fehleranzeigesignale FA1 bis FA3 erzeugbar sind. Damit werden dann einpolige Erdkurzschlüsse in dem Phasenleiter L1, L2 oder L3 signalisiert.

Tritt keines der Fehleranzeigesignale FA1 bis FA3 auf, dann wird ein Fehlersignal FK abgegeben, das einen mehrpoligen Erdkurzschluß signalisiert.

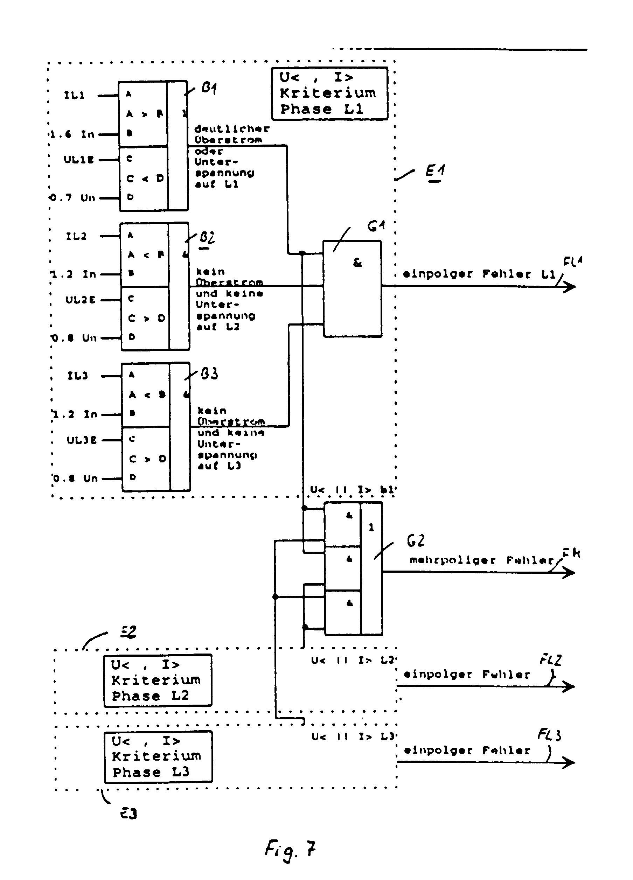

Der Block A2 gemäß Figur 6 kann beispielsweise so arbeiten, wie es aus Figur 7 entnehmbar ist. Dort sind unter anderem drei Blöcke B1, B2 und B3 dargestellt, in denen die Ströme IL1, IL2 und IL3 in den einzelnen Phasenleiter L1 bis L3 der dreiphasigen elektrischen Energieübertragungsleitung auf das Überschreiten von Grenzwerten B überwacht werden, wobei als Grenzwerte oberhalb des Nennstromes In liegende Stromwerte gewählt sind; außerdem erfolgt in den Blöcken B1 bis B3 eine Überprüfung der Phasenspannungen UL1E, UL2E und UL3E an den Phasenleitern L1 bis L3 nach Erde in bezug auf ein Unterschreiten eines Grenzwertes D, der mit Bezug auf die Nennspannung Un der Energieübertragungsleitung jeweils gewählt ist. Über interne Logikglieder der Blöcke B1 bis B3 werden Signale an ein nachgeordnetes UND-Glied G1 gegeben, das bei einem einpoligen Fehler am Phasenleiter L1 das Fehlerkennzeichnungssignal FL1 abgibt. Die Blöcke B1 bis B3 bilden zusammen mit dem UND-Glied 61 eine Erfassungseinheit EI.

Entsprechend ist jeweils eine weitere Erfassungseinheit E2 bzw. E3 für die Erfassung eines einpoligen Erdkurzschlusses in den Phasenleitern L2 und L3 vorgesehen, die an ihren Ausgängen die Fehlerkennzeichnungssignale FL2 und FL3 beim jeweiligen Erdkurzschluß abgeben. Wie der Block B1 so sind auch die entsprechenden Blöcke der Erfassungseinheiten E2 und E3 ausgangsseitig mit einem Logikglied G2 verbunden, das bei einem mehrpoligen Fehler das Fehlerkennzeichnungssignal FM abgibt. Über eine Logikanordnung L kann auch ein mehrpoliger Fehler erfaßt werden.

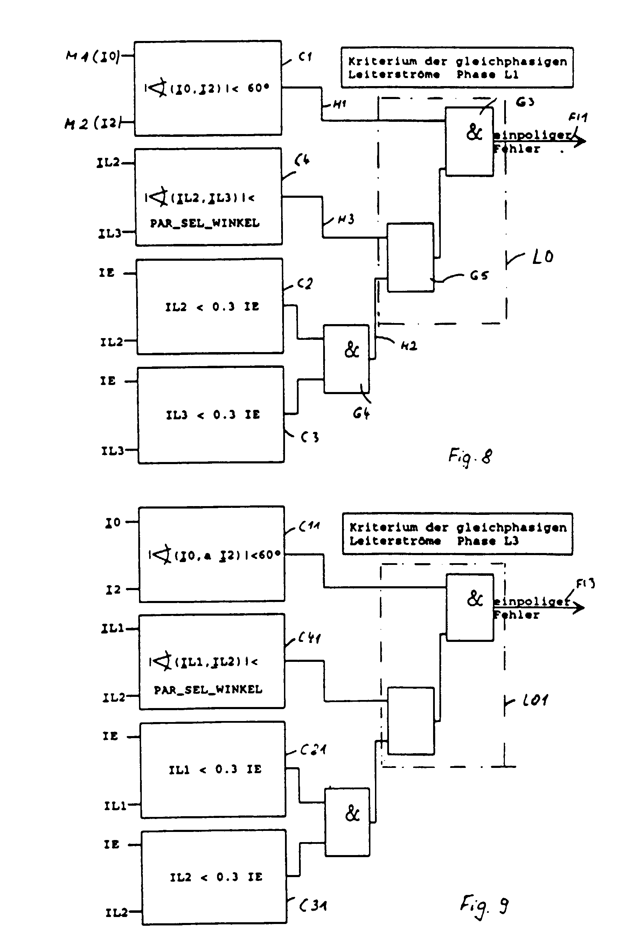

Eine schaltungstechnische Realisierung des Blocks A4 bezüglich des Überwachens des Phasenleiters L1 auf einen Erdkurzschluß ist in Figur 8 dargestellt. Dort ist ein Block C1 mit einer dem Strom I0 des Nullsystems entsprechenden Meßgröße M1 und einer dem Strom I2 des Gegensystems entsprechenden weiteren Meßgröße M2 beaufschlagt, die jeweils in einer Weise gebildet sind, wie es oben erläutert worden ist. Es wird in dem Block C1 der Phasenwinkel zwischen den Strömen I0 und I2 festgestellt und geprüft, ob der Phasenwinkel kleiner als 60° ist. Trifft dies zu, dann wird von dem Block C1 ein Hilfssignal H1 abgegeben und einem UND-Glied G3 einer Logikschaltung L0 zugeführt.

Die Anordnung gemäß Figur 8 weist ferner einen Block C2 und einen weiteren Block C3 auf, die einerseits eingangsseitig mit einer dem Erdstrom proportionalen Größe $I_E$ und andererseits mit dem Strom IL2 in dem Phasenleiter L2 und mit dem Strom IL3 in dem Phasenleiter L3 proportionalen Größen beaufschlagt sind. Sind die Ströme IL2 und IL3 kleiner als beispielsweise $0{,}3.I_E$ als Bruchteil des gemessenen Erdstromes $I_E$, dann wird von einem UND-Glied G4 ein weiteres Hilfssignal H2 erzeugt und an ein ODER-Glied G5 der Logikschaltung L0 abgegeben.

Einem weiteren Block C4 der Anordnung gemäß Fig. 8 werden aus den Strömen in den Phasenleitern L2 und L3 gebildete Ströme IL2 und IL3 zugeführt, und es wird der Phasenwinkel zwischen diesen beiden Strömen gebildet. Ist der Phasenwinkel kleiner als ein vorgegebener relativ kleiner Phasenwinkel, dann wird ein zusätzliches Hilfssignal H3 erzeugt und einem Eingang des ODER-Gliedes G5 zugeführt.

Liegen also das Hilfssignal H1 und das Hilfssignal H2 oder das Hilfssignal H3 vor, dann wird von dem UND-Glied G3 ein Fehleridentifizierungssignal FI1 abgegeben, das einen einpoligen Erdkurzschluß am Phasenleiter L1 kennzeichnet.

Wie oben bereits erläutert worden ist, kann unter Umständen auf den Block C4 und das ODER-Glied G5 verzichtet werden, um das Fehleridentifizierungssignal FI1 zu gewinnen.

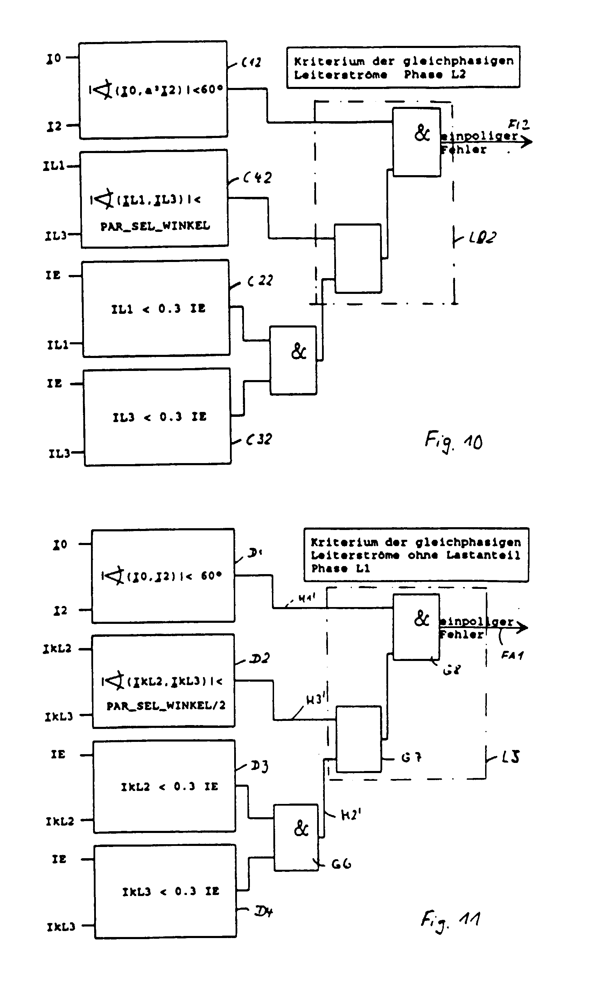

Entsprechend der Anordnung nach Fig. 8 arbeiten die Anordnungen nach den Figuren 9 und 10 nur mit dem Unterschied, daß dort in Blöcken C11 bzw. C12 anstelle des Stromes I2 des Gegensystems ein um 120° in der Phase gedrehter Strom aI2 bzw. ein Strom $a^2$I2 zum Phasenvergleich herangezogen wird, der um 240° gegenüber dem Strom I2 des Gegensystems in der Phase gedreht ist, und daß die Blöcke C21 bis C41 gemäß Fig. 9 und die Blöcke C22 bis C42 gemäß Fig. 10 eingangsseitig mit entsprechend anderen Eingangsströmen beaufschlagt sind. Im übrigen arbeiten die Anordnungen nach den Figuren 9 und 10 entsprechend der nach Figur 8, so daß mit der Anordnung nach Figur 9 am Ausgang einer Logikschaltung L01 das einen Erdkurzschluß am Phasenleiter L3 kennzeichnende Fehleridentifizierungssignal FI3 und mit der Anordnung nach Figur 10 am Ausgang einer Logikschaltung L02 das einen Erdkurzschluß am Phasenleiter L2 kennzeichnende Fehleridentifizierungssignal FI2 erzeugbar ist.

Die Anordnung nach Figur 11 stimmt im wesentlichen mit der nach Figur 8 überein; ein Unterschied besteht darin, daß bei der Anordnung nach Figur 11 neben einem Block D1 entsprechend dem Block C1 nach Fig. 8 ein Block D2 eingangsseitig mit Strömen IkL2 und IkL3 beaufschlagt ist, die im Rahmen der Laststromkorrektur gewonnen sind. Dies bedeutet, daß der Strom IkL2 entsprechend der nachfolgenden Beziehung (13) ermittelt ist:

$$\underline{I}_{kL2^{(t)}} = \underline{I}L2(t) - \underline{I}L2(t-t_s) \cdot e^{j\omega(t-t_s)} \tag{13}$$

In dieser Gleichung (13) ist mit $t_s$ ein Zeitpunkt vor Eintritt des Kurzschlusses bezeichnet, während t den Zeitpunkt angibt, zu dem ein Stromwert nach dem Eintreten des Erdkurzschlusses erfaßt wird. Entsprechend ist der Strom IkL3 nach der Gleichung (14) ermittelt:

$$\underline{I}_{kL3^{(t)}} = \underline{I}L3(t) - \underline{I}L3(t-t_s) \cdot e^{j\omega(t-t_s)} \tag{14}$$

Auch in den Blöcken D3 und D4 werden die korrigierten Stromwerte IkL2 und IkL3 weiterverarbeitet und jeweils mit Bruchteilen des Erdstromes verglichen.

Tritt am Ausgang des Blockes D1 ein viertes Hilfssignal H1', am Ausgang eines UND-Gliedes G6 ein fünftes Hilfssignal H2' und am Ausgang des Blockes D2 ein sechstes Hilfssignal H3' auf, dann wird über ein ODER-Glied G7 einer zusätzlichen Logikschaltung LS ein UND-Glied G8 zur Abgabe eines Fehleranzeigesignals FA1 angeregt, durch das ein einpoliger Fehler an dem Phasenleiter L1 signalisiert wird.

Genauso wie es oben im Zusammenhang mit der Erläuterung des Blockes A4 gemäß Fig. 6 beschrieben worden ist, enthält auch der Block A6 insgesamt drei der Anordnung gemäß Fig. 11, so daß neben dem Fehleranzeigesignal FA1 auch die entsprechenden anderen Fehleranzeigesignale FA2 und FA3 gewinnbar sind. Analog zu den Figuren 9 und 10 werden hierbei entsprechende Phasenwinkel und entsprechende Ströme berücksichtigt.

## Patentansprüche

1. Verfahren zum Erfassen eines Erdkurzschlusses auf einer elektrischen Energieübertragungsleitung mit drei Phasenleitern, bei dem

   - nach erfolgter Anregung aus den Strömen in den Phasenleitern (L1, L2, L3) abgeleitete Ströme (IL1, IL2, IL3) und/oder aus den Spannungen an den Phasenleitern (L1, L2, L3) abgeleitete Spannungen (UL1E, UL2E, UL3E) auf das Erreichen von Grenzwerten überwacht werden und
   - bei einem Überschreiten eines Grenzwertes hinsichtlich mindestens eines abgeleiteten Stromes (IL1, IL2, IL3) oder bei einem Unterschreiten eines weiteren Grenzwertes hinsichtlich mindestens einer abgeleiteten Spannung (UL1E, UL2E, UL3E) ein einen einpoligen oder mehrpoligen Fehler angebendes Fehlerkennzeichnungssignal (FL1,FL2, FL3, FM) erzeugt wird,

   **dadurch gekennzeichnet, daß** beim Ausbleiben eines Fehlerkennzeichnungssignals (FL1,FL2,FL3,FM)

- aus den abgeleiteten (IL1,IL2,IL3) Strömen eine dem Strom (I0) des Nullsystems entsprechende Meßgröße (M1) und eine dem Strom (I2) des Gegensystems entsprechende weitere Meßgröße (M2) gebildet werden,
- bei einem Erdkurzschluß eines Phasenleiters (z.B. L1) bei einem einen vorgegebenen Phasengrenzwinkel unterschreitenden Phasenwinkel zwischen den beiden Meßgrößen (M1,M2) ein Hilfssignal (H1) erzeugt wird,
- die aus den Strömen in den beiden jeweils anderen Phasenleitern (L2,L3) abgeleiteten Ströme (IL2,IL3) dahingehend überwacht werden, ob jeder dieser abgeleiteten Ströme (IL2,IL3) in seiner Größe unterhalb eines Bruchteils $(0,3.I_E)$ des erfaßten Erdstromes $(I_E)$ liegt, und ein weiteres Hilfssignal (H2) bei jeweils den Bruchteil des Erdstromes $(I_E)$ unterschreitenden Werten der abgeleiteten Ströme (IL2,IL3) erzeugt wird, und
- die Hilfssignale (H1,H2) in einer Logikschaltung (LO) überprüft werden,
- die beim Vorliegen beider Hilfssignale (H1,H2) ein den Erdkurzschluß des einen Phasenleiters (L1) kennzeichnendes Fehleridentifizierungssignal (FI1) abgibt.

2. Verfahren nach Anspruch 1,
**dadurch gekennzeichnet, daß**

- die aus den Strömen in den beiden jeweils anderen Phasenleitern (L2,L3) abgeleiteten Ströme (IL2,IL3) dahingehend überwacht werden, ob der von ihnen gebildete Phasenwinkel unterhalb einer vorgegebenen Phasendifferenz liegt und ein zusätzliches Hilfssignal (H3) bei die Phasendifferenz unterschreitendem Phasenwinkel erzeugt wird, und
- das zusätzliche Hilfssignal (H3) in der Logikschaltung (LO) überprüft wird,

- die beim Vorliegen des einen und des weiteren oder des zusätzlichen Hilfssignals (H1,H2;H1,H3) das den Erdkurzschluß des einen Phasenleiters (L1) kennzeichnende Fehleridentifizierungssignal (FI1) abgibt.

3. Verfahren nach Anspruch 1 oder 2,
**dadurch gekennzeichnet, daß** beim Ausbleiben eines Fehleridentifizierungssignals (FI1,FI2,FI3)

- Stromdifferenzmeßgrößen (IkL2, IkL3) gebildet werden, indem

- bezüglich jedes Phasenleiters (L1,L2,L3) von jedem abgeleiteten Strom (IL1,IL2,IL3) jeweils ein abgeleiteter Stromwert subtrahiert wird, der aus dem vor der Anregung fließenden Strom im jeweiligen Phasenleiter (L1,L2,L3) gebildet wird,

- bei einem Erdkurzschluß eines Phasenleiters (z.B. L1) bei einem einen vorgegebenen Phasengrenzwinkel unterschreitenden Phasenwinkel zwischen den beiden Meßgrößen (M1,M2) ein viertes Hilfssignal (H1') erzeugt wird,
- die Stromdifferenzmeßgrößen (IkL2,IkL3) dahingehend überwacht werden, ob jede dieser Stromdifferenzmeßgrößen (IkL2,IkL3) in ihrer Größe unterhalb eines Bruchteils $(0,3.I_E)$ des erfaßten Erdstromes $(I_E)$ liegt, und ein fünftes Hilfssignal (H2') bei jeweils den Bruchteil $(0,3.I_E)$ des Erdstromes $(I_E)$ unterschreitenden Werten der abgeleiteten Ströme (IkL2,IkL3) erzeugt wird, und
- die vierten (H1') und fünften (H2') Hilfssignale in einer zweiten Logikschaltung (LS) überprüft werden,

- die beim Vorliegen dieser beiden Hilfssignale (H1',H2') ein den Erdkurzschluß des einen Phasenleiters kennzeichnendes Fehleranzeigesignal (FA1) abgibt.

4. Verfahren nach Anspruch 3,
**dadurch gekennzeichnet, daß**

- die den beiden jeweils anderen Phasenleitern (L2,L3) zugeordneten Stromdifferenzmeßgrößen (IkL2,IkL3) dahingehend überwacht werden, ob der von ihnen gebildete Phasenwinkel unterhalb einer vorgegebenen Phasendifferenz liegt, und ein sechstes Hilfssignal (H3') bei die Phasendifferenz unterschreitendem Phasenwinkel erzeugt wird, und
- das sechste Hilfssignal (H3') in der zweiten Logikschaltung (LS) überprüft wird,

- die beim Vorliegen des vierten und des fünften oder des sechsten Hilfssignals (H1',H2';H1',H3') das den Erdkurzschluß des einen Phasenleiters (L1) kennzeichnende Fehleranzeigesignal (FA1) abgibt.

5. Verfahren nach Anspruch 4,

**dadurch gekennzeichnet, daß**

- mit der zweiten Logikschaltung (LS) überprüft wird, ob nach erfolgter Anregung ein Fehleranzeigesignal (FA1,FA2,FA3) aufgetreten ist, und
- bei ausbleibendem Fehleranzeigesignal (FA1,FA2,FA3) ein einen dreipoligen Erdkurzschluß anzeigendes Fehlermeldesignal (FK) erzeugt wird.


## Claims

1. A method of detecting an earth fault on an electric power transmission line comprising three phase conductors wherein

   - following activation, currents (IL1, IL2, IL3) derived from the currents in the phase conductors (L1, L2, L3) and/ or voltages (UL1E, UL2E, UL3E) derived from the voltages on the phase conductors (L1, L2, L3) are monitored for the attainment of limit values and
   - in the event of an overshooting of a limit value for at least one derived current (IL1, IL2, IL3) or in the event of an undershooting of a further limit value for at least one derived voltage (UL1E, UL2E, UL3E), a fault characterising signal (FL1, FL2, FL3, FM) indicating a single pole or multi-pole fault is generated,

   characterised in that in the absence of a fault characterising signal (FL1, FL2, FL3, FM),

   - from the derived currents (IL1, IL2, IL3), a measured quantity (M1) corresponding to the current (I0) of the zero-sequence system and a further measured quantity (M2) corresponding to the current (I2) of the negative-sequence system are formed,
   - on the occurrence of an earth fault in one phase conductor (e.g. L1), in the case of a phase angle between the two measured quantities (M1, M2) undershooting a given phase limit angle, an auxiliary signal (H1) is generated,
   - the currents (IL2, IL3) derived from the currents in the two respective other phase conductors (L2, L3) are monitored to determine whether the value of each of these derived currents (IL2, IL3) undershoots a fraction $(0.3 \cdot I_E)$ of the detected earth current $(I_E)$ and in the case of values of the derived currents (IL2, IL3) in each case undershooting the fraction of the earth current $(I_E)$, a further auxiliary signal (H2) is generated and
   - the auxiliary signals (H1, H2) are checked in a logic circuit (LO),

     - which, in the presence of the two auxiliary signals (H1, H2), emits a fault identification signal (FI1) indicating the earth fault in the one phase conductor (L1).

2. A method according to Claim 1, characterised in that

   - the currents (IL2, IL3) derived from the currents in the two respective other phase conductors (L2, L3) are monitored to determine whether the phase angle which they form undershoots a given phase difference and in the case of a phase angle undershooting the phase difference an additional auxiliary signal (H3) is generated and
   - the additional auxiliary signal (H3) is checked in the logic circuit (LO)

     - which, in the presence of the one and the further of the additional auxiliary signal (H1, H2; H1, H3), emits the fault identification signal (FI1) indicating the earth fault in the one phase conductor (L1).

3. A method according to Claim 1 or 2, characterised in that in the absence of a fault identification signal (FI1, FI2, FI3),

   - current-difference measured quantities (IkL2, IkL3) are formed in that

     - for each phase conductor (L1, L2, L3), from each derived current (IL1, IL2, IL3) there is in each case subtracted a derived current value formed from the current flowing prior to activation in the respective phase conductor (L1, L2, L3),

   - on the occurrence of an earth fault in one phase conductor (e.g. L1), in the case of a phase angle between the two measured quantities (M1, M2) undershooting a given phase limit angle, a fourth auxiliary signal (H1') is generated,

- the current-difference measured quantities (IkL2, IkL3) are monitored to determine whether the value of each of these current-difference measured quantities (IkL2, IkL3) undershoots a fraction $(0.3 \cdot I_E)$ of the detected earth current $(I_E)$, and a fifth auxiliary signal (H2') is generated in the case of values of the derived currents (IkL2, IkL3) in each case undershooting the fraction $(0.3 \cdot I_E)$ of the earth current $(I_E)$ and
- the fourth auxiliary signal (H1') and fifth auxiliary signal (H2') are checked in a second logic circuit (LS)

  - which, in the presence of these two auxiliary signals (H1', H2'), emits a fault indication signal (FA1) indicating the earth fault in the one phase conductor.

4. A method according to Claim 3, characterised in that

  - the current-difference measured quantities (IkL2, IkL3) assigned to the two respective other phase conductors (L2, L3) are monitored to determine whether the phase angle which they form undershoots a given phase difference, and a sixth auxiliary signal (H3') is generated in the case of a phase angle undershooting the phase difference and the sixth auxiliary signal (H3') is checked in the second logic circuit (LS)

    - which, in the presence of the fourth and fifth or sixth auxiliary signal (H1', H2'; H1', H3'), emits the fault indication signal (FA1) indicating the earth fault in the one phase conductor (L1).

5. A method according to Claim 4, characterised in that

  - with the second logic circuit (LS) it is checked whether, following activation, a fault indication signal (FA1, FA2, FA3) has occurred and
  - in the absence of a fault indication signal (FA1, FA2 FA3), a fault reporting signal (FK) indicating a three-pole earth fault is generated.

## Revendications

1. Procédé pour détecter un court-circuit à la terre sur une ligne électrique de transmission d'énergie comportant trois conducteurs de phase, dans lequel

  - après une excitation réussie de courants (IL1, IL2, IL3) dérivés des courants dans les conducteurs (L1, L2, L3) de phase ou de tensions dérivées des tensions sur les conducteurs (L1, L2, L3) de phase, on surveille que des valeurs limites sont atteintes et
  - dans lequel, dans le cas où on est au-dessus d'une valeur limite concernant au moins un courant (IL1, IL2, IL3) dérivé ou dans le cas où on est en dessous d'une valeur limite supplémentaire concernant au moins une tension (UL1E, UL2E, UL3E) dérivée, un signal (FL1, FL2, FL3, FM) de caractérisation de défaut indiquant un défaut unipolaire ou un défaut multipolaire est produit,

  caractérisé en ce que, en cas d'absence d'un signal (FL1, FL2, FL3, FM) de caractérisation de défaut,

  - on forme à partir des courants (IL1, IL2, IL3) dérivés, une valeur (M1) ) de mesure correspondant au courant (I0) du système neutre et une valeur (M2) de mesure supplémentaire correspondant au courant (I2) du système inverse,
  - en cas d'un court-circuit à la terre d'un conducteur de phase (par exemple L1), il est produit un signal (H1) auxiliaire pour un angle de phase entre les deux valeurs (M1, M2) de mesure inférieur à un angle limite de phase prescrit,
  - on surveille en revanche, pour les courants (IL2, IL3) dérivés des courants dans les deux autres conducteurs (L2, L3) de phase, si la valeur de chacun de ces courants (IL2, IL3) dérivés est inférieure à une fraction $(0,3.I_E)$ de courant $(I_E)$ de terre détectée, et un signal (H2) auxiliaire supplémentaire est produit pour des valeurs des courants (IL2, IL3) dérivés inférieurs à la fraction du courant $(I_E)$ de terre, et
  - on contrôle les signaux (H1, H2) auxiliaires dans un circuit (LO) logique,
  - qui, en présence des deux signaux (H1, H2) auxiliaires, fournit un signal (FI1) d'identification de défaut caractérisant un court-circuit à la terre de l'un des conducteurs de phase (L1).

2. Procédé suivant la revendication 1,

caractérisé en ce que,

- on surveille en revanche, pour les courants (IL2, IL3) dérivés des courants dans les deux autres conducteurs (L2, L3) de phase, si l'angle de phase formé par eux est inférieur à une différence de phase prescrite, et un signal (H3) auxiliaire supplémentaire est produit pour un angle de phase inférieur à la différence de phase, et
- on vérifie le signal (H3) supplémentaire dans le circuit logique
- qui, en présence de l'un et l'autre des signaux (H1,H2) auxiliaires ou de l'un (H1) des signaux auxiliaires et du signal (H3) auxiliaire supplémentaire fournit le signal (Fi1) d'identification de défaut caractérisant le court-circuit à la terre de l'un (L1) des conducteurs de phase.

3. Procédé suivant la revendication 1 ou 2 ,
   caractérisé en ce que, en cas d'absence d'un signal (FI1, FI2, FI3) d'identification de défaut ,

   - on forme des grandeurs (IkL2, IkL3) de mesure de différence de courant,
   - en soustrayant, pour chaque conducteur (L1, L2, L3) de phase, de chaque courant (L1, L2, L3) dérivé une valeur de courant dérivé qui est formée du courant passant avant l'excitation dans le conducteur (L1, L2, L3) de phase associée,
   - dans le cas d'un court-circuit à la terre d'un conducteur de phase par exemple (L1), il est produit un quatrième signal (H1') auxiliaire pour un angle de phase entre les deux valeurs (M1, M2) de mesure inférieur à un angle limite de phase prescrit,
   - pour les valeurs (IkL2, IkL3) de mesure de différence de courant, on surveille en revanche si la valeur de chacune de ces valeurs (IkL2, IkL3) de mesure de différence de courant est inférieure à une fraction $(0,3.I_E)$ du courant $(I_E)$ de terre détecté, et un cinquième signal (H2') auxiliaire est produit pour des valeurs des courants IkL2, IkL3) dérivés inférieures à la fraction $(0,3.I_E)$ du courant $(I_E)$ de terre, et
   - on vérifie les quatrième (H1') et cinquième (H2') signaux auxiliaires dans un deuxième circuit (LS) logique
   - qui, en présence de cas deux signaux (H1',H2') auxiliaires, fournit un signal (FA1) d'indication de défaut caractérisant le court-circuit à la terre de l'un des conducteurs de phase.

4. Procédé suivant la revendication 3,
   caractérisé en ce que

   - pour les valeurs (IkL2, IkL3) de mesure de différence de courant associé aux deux autres conducteurs (L2, L3) de phase, on surveille en revanche si l'angle de phase formé par elle est inférieur à une différence de phase prescrite, et un sixième signal (H3') auxiliaire est produit pour l'angle de phase inférieur à la différence de phase, et
   - on vérifie le sixième signal (H3') auxiliaire dans le deuxième circuit (LS) logique,
   - qui, en présence des quatrième (H1') et cinquième (H2') signaux auxiliaires ou des quatrième (H1') et sixième (H3') signaux auxiliaires, fournit le signal (FA1) d'indication de défaut caractérisant le court-circuit à la terre de l'un des conducteurs de phase (L1).

5. Procédé suivant la revendication 4,
   caractérisé en ce que

   - on vérifie par le deuxième circuit (LS) logique si un signal (FA1, FA2, FA3) d'indication de défaut est apparu après une excitation réussie, et
   - en cas d'absence de signal (FA1, FA2, FA3) d'indication de défaut, il est produit un signal (FK) de signalisation de défaut indiquant un court-circuit à la terre tripolaire.

Fig. 1

Fig 2

Fig. 3

Fig. 4

Fig. 5

14

EP 0 795 222 B1

Fig. 6

Fig. 7

M 1 (I0) — C1

$|\sphericalangle (I0, I2)| < 60°$

M 2 (I2) —

Kriterium der gleichphasigen
Leiterströme   Phase L1

H1

& G3

einpoliger
Fehler

F11

IL2 —

C4

$|\sphericalangle (IL2, IL3)| <$

PAR_SEL_WINKEL

IL3 —

H3

G5

L0

IE —

C2

IL2 < 0.3 IE

IL2 —

&

H2

IE —

IL3 < 0.3 IE

IL3 —

G4

C3

*Fig. 8*

I0 —

C11

$|\sphericalangle (I0, a\ I2)| < 60°$

I2 —

Kriterium der gleichphasigen
Leiterströme   Phase L3

&

einpoliger
Fehler

F13

IL1 —

C41

$|\sphericalangle (IL1, IL2)| <$

PAR_SEL_WINKEL

IL2 —

L01

IE —

C21

IL1 < 0.3 IE

IL1 —

&

IE —

IL2 < 0.3 IE

IL2 —

C31

*Fig. 9*

17

Fig. 10

Fig. 11